# EUROPEAN PATENT SPECIFICATION

(11) **EP 1 600 981 B1**
(45) Date of publication and mention of the grant of the patent: **02.01.2008**
(21) Application number: 05104268.7
(22) Date of filing: 19.05.2005
(51) Int. Cl.: G11C 16/10

(54) **Stored data rewriting system for on-board control unit**
System zum Wiedereinschreiben gespeicherter Daten für eine bordgestützte Einheit
Système pour réécrire des données stockées pour un système embarqué

(30) Priority: 19.05.2004 JP 2004149236
(43) Date of publication of application: 30.11.2005
(73) Proprietor: Keihin Corporation, Shinjuku-ku, Tokyo (JP)
(72) Inventor: Watanabe, Hideki Keihin Corp. Tochigi R&D Center, Takanezawa-machi,Shioya-gun Tochigi (JP); Okuyama, Fumihiko Keihin Corp. Tochigi R&D Center, Takanezawa-machi,Shioya-gun Tochigi (JP)
(74) Representative: Staudt, Hans-Peter

(56) References cited:
- EP-A- 0 398 654
- US-A- 5 278 759

## Description

### BACKGROUND OF THE INVENTION

### 1. Field of the Invention

The present invention relates to a rewriting system for rewriting data stored in a memory of an on-board control unit.

### 2. Description of the Related Background Art

An on-board control unit designated as an ECU is provided in a vehicle for controlling driving conditions such as an ignition time of an engine, an air-fuel mixture ratio, an fuel injection quantity and the like, as well as operation of in-vehicle equipment such as power windows, an air conditioner and the like. The on-board control unit is normally made up of a microcomputer consisting of a CPU (central processing unit) and a memory including a ROM (read only memory). Data such as programs are written in the ROM to allow the CPU to perform control operations.

Data stored in the ROM is sometimes updated for better control. When updating the data, a rewriting unit is connected to the on-board control unit, so that communications can be established between the on-board control unit and the rewriting unit. Data for rewriting is transferred to the on-board control unit, whereby the stored data in the ROM within the on-board control unit is rewritten (JP-A-2003-122622).

In the conventional rewriting system, however, rewriting data is sequentially transferred from the rewriting unit to the on-board control unit to be received thereby, and the data so received is then written into the ROM. Thus, since rewriting time is needed in accordance with the volume of rewriting data, it has been desired to shorten the rewriting time.

### SUMMARY OF THE INVENTION

Then, an object of the present invention is to provide a rewriting system, an on-board control unit and a rewriting unit which can realize the shortening of rewriting time for rewriting data in a memory of an on-board control unit.

According to the invention, there is provided a rewriting system in which rewriting data is transmitted from an external rewriting unit to an on-board control unit having a nonvolatile memory which stores data for executing at least control of an engine of a vehicle so as to rewrite the stored data in the nonvolatile memory, wherein the rewriting unit comprises transmission control means for transmitting the rewriting data for each predetermined data transfer unit as a data transfer command together with specified position data which represents a portion to be rewritten of the nonvolatile memory which corresponds to the rewriting data that is transmitted by the predetermined data transfer unit and prohibiting the transmission of the data transfer command which contains the rewriting data when the whole of the rewriting data that is transmitted by the predetermined data transfer unit represents a predetermined value, and wherein the on-board control unit comprises receiving means for receiving the data transfer command transmitted from the rewriting unit, and writing control means for writing the rewriting data contained in the data transfer command received by the receiving means to the rewriting portion of the nonvolatile memory represented by the specified position data in the data transfer command and writing data representing the predetermined value in all portions to be rewritten of the nonvolatile memory where the rewriting data cannot be obtained from the data transfer command received by the receiving means.

According to the invention, there is provided an on-board control unit having a nonvolatile memory which stores data for executing at least control of an engine of a vehicle, the on-board control unit comprising: receiving means for receiving a data transfer command transmitted from an external rewriting unit; and writing control means for writing rewriting data contained in the data transfer command received by the receiving means to a portion to be rewritten of the nonvolatile memory represented by specified position data in the data transfer command received and writing data representing a predetermined value in all portions to be rewritten of the nonvolatile memory where the rewriting data cannot be obtained from the data transfer command received by the receiving means.

According to the invention, there is provided a rewriting unit for transmitting to an on-board control unit having a nonvolatile memory which stores data for executing at least control of an engine of a vehicle rewriting data for rewriting the stored data in the nonvolatile memory, the rewriting unit comprising: transmission control means for transmitting the rewriting data for each predetermined data transfer unit as a data transfer command together with specified position data which represents a rewriting portion of the nonvolatile memory which corresponds to the rewriting data that is transmitted by the predetermined data transfer unit and prohibiting the transmission of the data transfer command which contains the rewriting data when the whole of the rewriting data that is transmitted by the predetermined data transfer unit represents a predetermined value.

### BRIEF DESCRIPTION OF THE DRAWINGS

Fig. 1 is a block diagram showing an embodiment of the present invention;
Fig. 2 is a drawing showing a storage area of a RAM;
Fig. 3 is a drawing showing a storage area of a ROM;
Fig. 4 is a drawing showing communications occurring between a rewriting unit and an ECU when rewriting data;
Fig. 5 is a drawing showing the configuration of a data transfer command;
Fig. 6 is a flowchart showing a data transfer command transmission process;
Fig. 7 is a flowchart showing an ECU control operation;
Fig. 8 is a flowchart showing a ROM deletion request receiving process;
Fig. 9 is a flowchart showing a rewriting mode transition process;
Fig. 10 is a flowchart showing an ECU rewriting control process;
Fig. 11 is a flowchart showing a ROM deletion process;
Fig. 12 is a flowchart showing a ROM writing process;
Fig. 13 is a flowchart showing a transferred data receiving process;
Fig. 14 is a flowchart showing a data transfer completion receiving process; and
Figs. 15A to 15C are drawings which explain rewriting operations.

### DETAILED DESCRIPTION OF THE INVENTION

An embodiment of the invention will be described below by reference to the accompanying drawings.

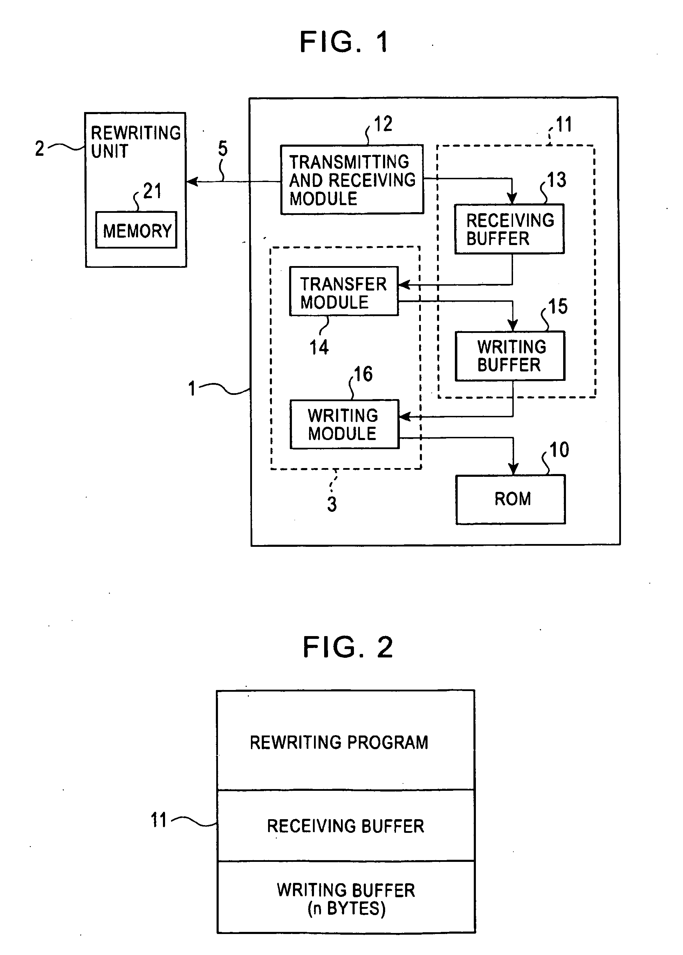

Fig. 1 shows a rewriting system to which a rewriting method according to the invention is applied. This system includes an ECU 1 for an internal combustion engine control system and a rewriting unit 2.

The ECU 1 is installed in a vehicle and includes a CPU (central processing unit) 3, an I/O interface and a memory. The CPU 3 receives detection signals from a crank angle sensor, an intake manifold air pressure sensor, an engine coolant temperature sensor and the like via the input interface, calculates control values such as a fuel injection quantity and an ignition time of the internal combustion engine and supplies control signals based on results of the calculations to a fuel injector and an ignition system via the output interface. The memory is made up of a ROM (read only memory) 10 and a RAM (random access memory) 11. The ROM 10 is made up of a flash ROM. Programs and data for controlling the CPU and a rewriting program for the ROM 10 itself are written in the ROM 10. In this embodiment, the programs and data in the ROM 10 are rewritten. Programs and data which are necessary for operation of the CPU 3 are stored temporarily in the ROM 10. In addition, the rewriting program is written in the RAM 11 as shown in Fig. 2 when rewriting the ROM 10, and additionally, part of the RAM 11 is used as a receiving buffer 13 and a writing buffer 15, which are shown in Fig. 1.

Fig. 1 shows only a portion within the ECU 1 which is related to the rewriting of the ROM 10. This rewriting related portion is made up of, in addition to the ROM 10, a transmitting and receiving module 12, the receiving buffer 13, a transfer module 14, the rewriting buffer 15 and a writing module 16. The transmitting and receiving module 12 is an I/O interface for performing serial communication with the rewriting unit 2 via a cable 5. The receiving buffer 13 is connected to the transmitting and receiving module 12. When data sent from the rewriting unit 2 is received at the transmitting and receiving module 12, the received data is held in the receiving buffer 13 temporarily. The transfer module 14 is interposed between the receiving buffer 13 and the writing buffer 15 and writes the data held in the receiving buffer 13 to the writing buffer 15. The writing buffer 15 consists of n bytes and has a storage area which is as large as pages to be rewritten of the ROM 10 in size. A page to be rewritten constitutes a data rewriting unit. The writing module 16 writes the data retained in the writing buffer 15 to a corresponding page to be rewritten of the ROM 10.

The CPU of the ECU 1 functions as the transfer module 14 and the writing module 16 in the rewriting related portion.

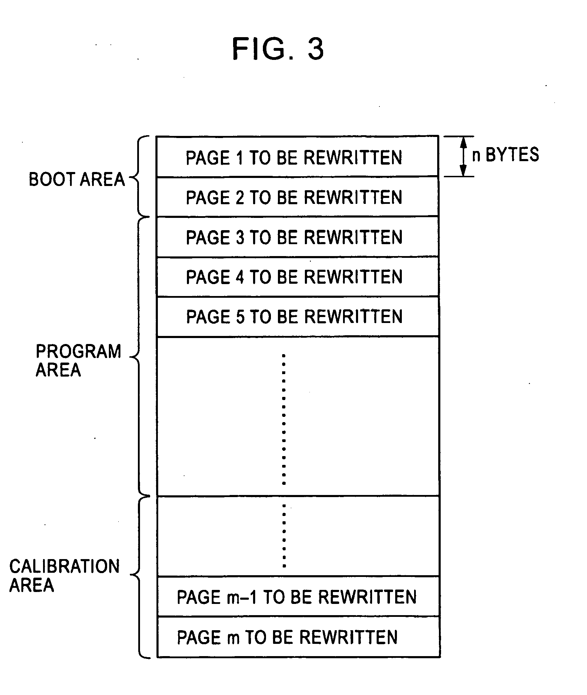

The storage area of the ROM 10 is, as shown in Fig. 3, has a boot area, a program area and a calibration area and includes pages 1 to m as pages to be rewritten. The storage capacity of the ROM 10 is mxn bytes. The boot area is an area for storing the rewriting program of the ROM 10 itself. The program area is an area for storing the engine control program. The calibration area is an area for storing a program for correcting the engine control.

The rewriting unit 2 includes a memory 21 a transmitting and receiving module (not shown) for serial communication between a memory 21 which can store data to be written to the ROM 10 of the ECU 1 and the ECU 1.

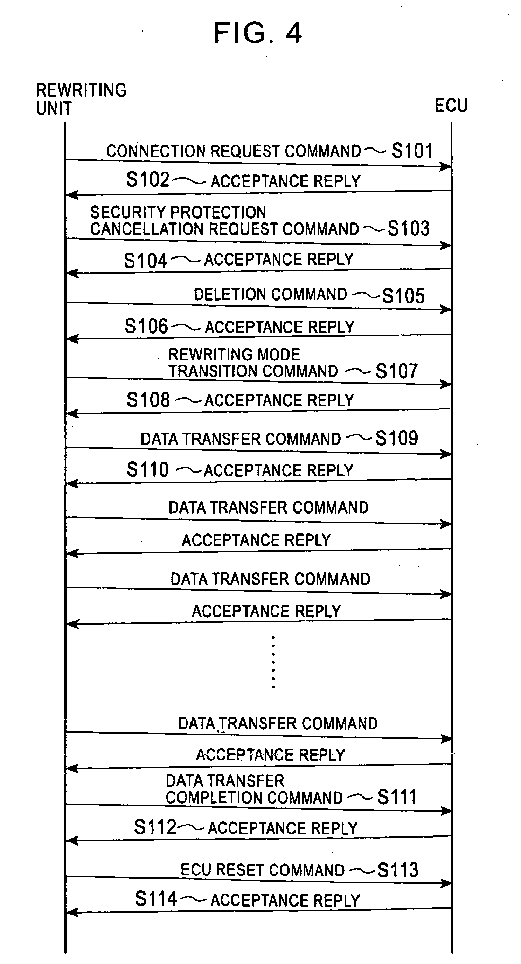

When rewriting data, transmission and reception are performed between the rewriting unit 2 and the ECU 1 as shown in Fig. 4. Namely, a connection request command is transmitted from the rewriting unit 2 to the ECU 1 according to an input operation from an operating module (not shown) of the rewriting unit 2 (step S101). An acceptance reply is transmitted from the ECU 1 to the rewriting unit 2 with respect to the connection request (step S102), and when the acceptance reply is received at the rewriting unit 2, a security protection cancellation request command is transmitted from the rewriting unit 2 to the ECU 1 (step S103).

An acceptance replay to the security protection cancellation request command is transmitted from the ECU 1 (step S104), and when the rewriting unit 2 receives the reply, a deletion command is further transmitted from the rewriting unit 2 to the ECU 1 (step S105). The deletion command indicates an area of the ROM 10 where rewriting is to be performed. The ECU 1 transmits an acceptance reply to the rewriting unit 2 with respect to the deletion command in a ROM deletion request receiving process, which will be described later on (step S106). When the rewriting unit 2 receives the acceptance replay with respect to the deletion command from the ECU 1, a rewriting mode transition command is transmitted from the rewriting unit 2 to the ECU 1 (step S107). The ECU 1 transmits an acceptance reply to the rewriting unit 2 with respect to the rewriting mode transition command in a rewriting mode transition process, which will be described later on.

When the rewriting unit 2 receives the acceptance reply from the ECU 1 with respect to the rewriting mode transition command (step S108), a data transfer command is transmitted from the rewriting unit 2 to the ECU 1 (step S109). When receiving the data transfer command, the ECU 1 holds the command in the receiving buffer 13 temporarily and thereafter writes data included in the data transfer command to the writing buffer 15. In the ECU 1, when data for one page is formed in the writing buffer 15, writing to the ROM 10 is executed by a ROM writing process. In addition, when the data is written to the writing buffer 15, an acceptance reply with respect to the data transfer command is transmitted from the ECU1 to the rewriting unit 2 (step S110). The communication of a data transfer command and an acceptance reply thereto is repeated until the whole of data necessary to rewrite the data in the ROM 10 is transmitted completely.

When transmitting a final data transfer command for the data necessary to rewrite the data in the ROM 10 and receiving an acceptance reply thereto from the ECU 1, the rewriting unit 2 transmits a data transfer completion command to the ECU 1 (step S111). In the ECU 1, replying to the data transfer completion command, a data transfer completion receiving process is executed, and an acceptance replay is transmitted to the rewriting unit 2 in the event that the data in the ROM 10 has completely been rewritten (step S112). Thereafter, the rewriting unit 2 transmits an ECU reset command to the ECU 1 (step S113), and the ECU 1 is restored to the initial state in response to the ECU reset command and transmits an acceptance reply to the rewriting unit 2 (step S114).

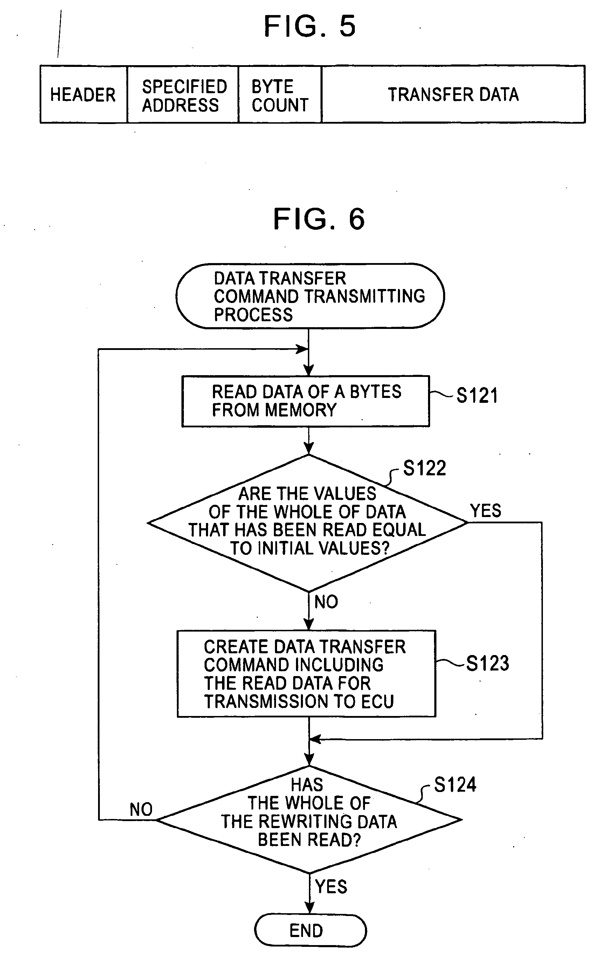

As shown in Fig. 5, the data transfer command that is transmitted to the ECU 1 by the rewriting unit 2 is made up of a header, a specified address, a byte count and data to be transferred, which are arranged in that order. The header represents that the command is a data transfer command. The specified address is position data which represents an address of the ROM 10 where data to be transferred is written. The byte count is a data transfer unit and represents the byte count of the data to be transferred. The data to be transferred is data to be written to the ROM 10.

Assuming that the size of data that is transferred by a single transmission of a data transfer command by the rewriting unit 2, namely, the byte count is A bytes, the A bytes are equal to or less than n bytes which correspond to a page to be rewritten, and a remainder of n/A is zero. The A bytes do not have to be constant but may be a byte count which is properly variable.

When the rewriting unit transmits a data transfer command, as shown in Fig. 6, data corresponding to the A bytes is first read from the memory 21 in the order of pages to be rewritten (step S121), and whether or not the whole of the data corresponding to the A bytes so read represents an initial value is determined (step S122). Namely, whether or not each piece of the byte data of A bytes is at its initial value is determined. Here, the initial value corresponds to initial value used to initialize the whole of the storage area of the writing buffer 15 in the rewriting mode transition process in step S25, which will be described later on, or ROM writing process in step S56, both the processes being performed within the ECU 1, and are, for example, FF of a hexadecimal number for each byte.

If the whole of the data of A bytes is not at the initial value, a data transfer command including the data of A bytes that has been read is created in the rewriting unit 2 for transmission to the ECU 1 (step S123). Then, whether or not the whole of the rewriting data stored in the memory 21 has been read is determined (step S124). If the whole of the rewriting data has not yet been read, the flow returns to step S121 to read the next data of A bytes.

On the other hand, if the whole of the data of A bytes that has been read is at the initial value, jump to step S124 for execution by bypassing step S123. Namely, the read A-byte data of the initial value train is not transmitted to the ECU 1. Consequently, when it occurs that the whole of the data of A bytes that has been read is at the initial value, addresses of rewriting data to be sent to the ECU 1 are caused to discontinue. This data transfer command transmitting process corresponds to the transmission control means of the rewriting unit 2.

The operation of the ECU 1 with respect to the rewriting unit 2, which performs the aforesaid data transfer operation, will be described next.

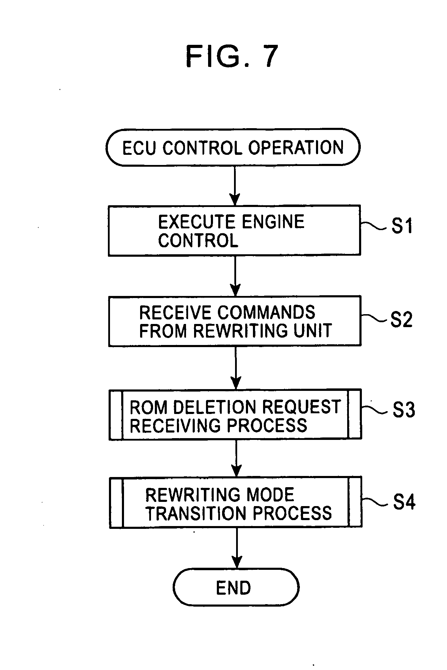

As shown in Fig. 7, the CPU of the ECU 1 executes the control of the engine including on-board equipment (step S1), receives commands from the rewriting unit 2 (step S2), and thereafter executes a ROM deletion request receiving process (step S3) and a rewriting mode transition process (step S4) in response to the commands so received. When a command from the rewriting unit 2 is received at the transmitting and receiving module 12, the command so received is then retained in the receiving buffer 13. Note that the rewriting mode transition process corresponds to the writing control means.

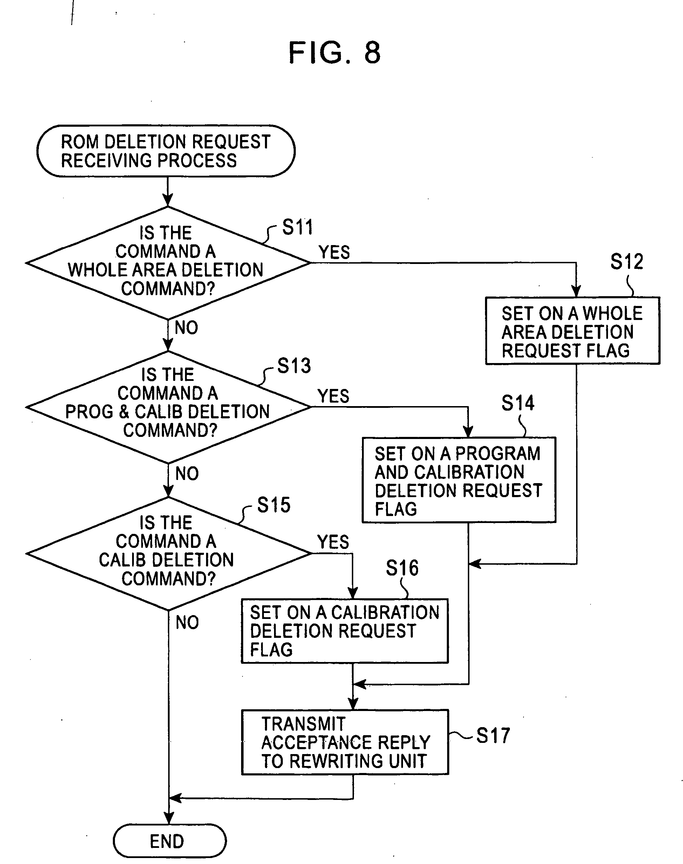

As shown in Fig. 8, in the ROM deletion request receiving process, the CPU 3 first determines whether or not the received command is a whole area deletion command (step S11). Since a command from the rewriting unit 2 has a header representing the type of command, the type of the command received can be determined from the header thereof. The whole area deletion means the deletion of the boot area, program area and calibration area. If the received command is a whole area deletion command, a whole area deletion request flag is set on (namely, to 1) (step S12). If the received command is not the whole area deletion command, whether or not the received command is a deletion command of both the program and calibration areas is determined (step S13). If the received command is a deletion command for both the program and calibration areas, a program and calibration deletion request flag is set on (step S14). If the received command is not the deletion command for both the program and calibration areas, whether or not the received command is a deletion command for the calibration area is determined (step S15). If the received command is a deletion command for the calibration area, a calibration deletion request flag is set on (step S16). When the step S12, S14 or S16 is executed, an acceptance reply is transmitted to the rewriting unit 2 (step S17).

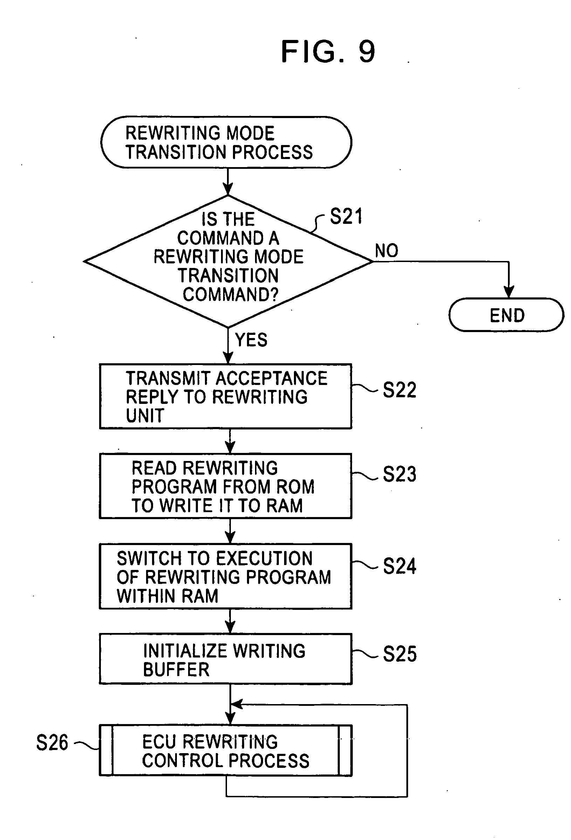

As shown in Fig. 9, in the rewriting mode transition process, the CPU 3 first determines whether or not the received command is a rewriting transition command is determined (step S21). If the received command is not a rewriting mode transition command, the rewriting mode transition process is terminated immediately. On the other hand, the received command is the rewriting mode transition command, an acceptance replay is transmitted to the rewriting unit 2 (step S22). Thereafter, the CPU 3 reads out the rewriting program from the ROM 10 to write it to the RAM 11 (step S23) and switches to the execution of the rewriting program within the RAM 11 (step S24). The CPU 3, which has operated in accordance with the program of the ROM 10 until the execution in step S24, now operates in accordance with the rewriting program within the RAM11. Furthermore, the writingbuffer 15 is initialized (step S25). Namely, the setting of the whole of the storage area of the writing buffer 15 to the initial value (for example, FF of a hexadecimal number) is performed. After having executed the step S25, the CPU 3 repeatedly executes an ECU rewriting control process (step S26).

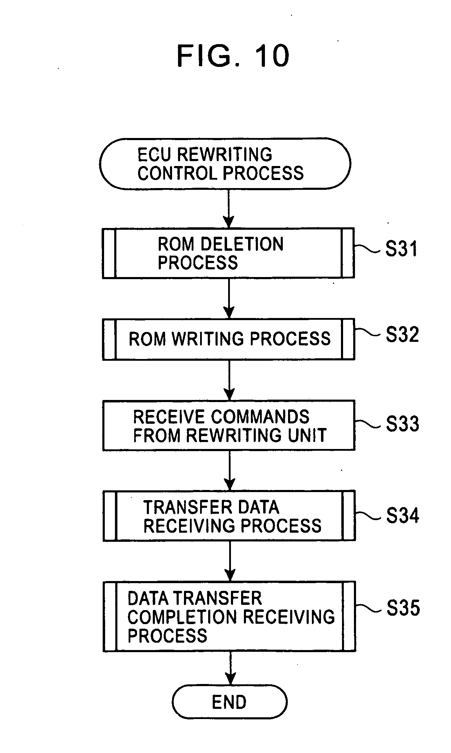

In the ECU rewriting control process, as shown in Fig. 10, the CPU 3 executes a ROM deletion process (step S31) and a ROM writing process (step S32), receives commands from the rewriting unit 2 (step S33), and furthermore, executes a transfer data receiving process (step S34) and a data transfer completion receiving process (step S35). The ROM deletion process in step S31 and the ROM writing process in step S32 are executed by the writing module 16. The transfer data receiving process in step S34 and the data transfer completion receiving process in step S35 are executed by the transfer module 14. In addition, part of the ROM writing process in step S32 (steps S59 to S62, which will be described later on) is executed by the transfer module 14.

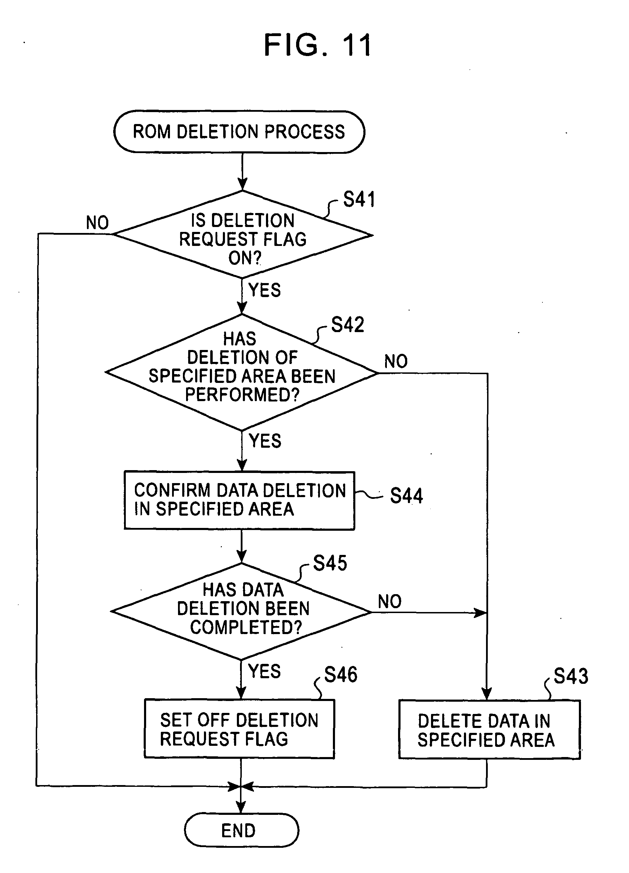

In the ROM deletion process, as shown in Fig. 11, the CPU 3 determines whether or not a deletion request flag (step S41). In the ROM deletion request receiving process, whether or not any one of a whole area deletion request flag, a Prog & Calib deletion request flag and a Calib deletion request flag is on is determined. If any one of the deletion request flags is on, whether or not the deletion of a specified area has been executed is determined (step S42). If a deletion operation with respect to data within a specified area represented by one of the deletion request flags of the ROM 10 has not yet been performed, the data in the specified area is deleted (step S43). On the other hand, if the deletion operation with respect to data within the specified area represented by one of the deletion request flags of the ROM 10 has already been performed, the deletion of the data in the specified area is confirmed (step S44), and whether or not the data deletion has been completed is determined (step S45). If the data deletion in the specified area has not yet been completed, proceed to step S43 to delete the data in the specified area. If the data deletion has been completed, the one of the deletion request flags is set on (or, set to 0) (step S46).

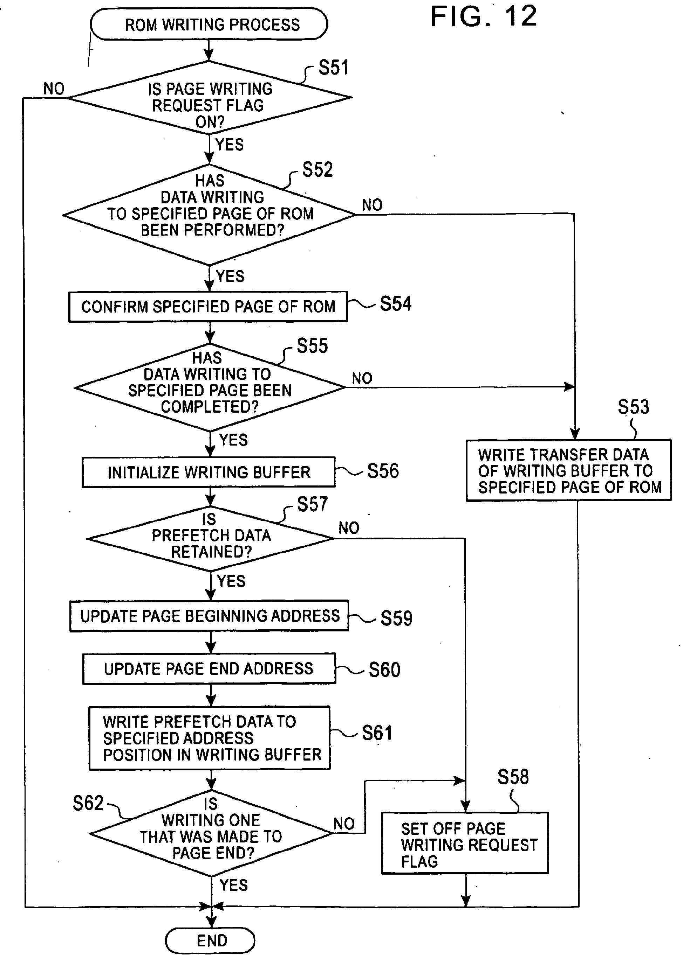

In the ROM writing process, as shown in Fig. 12, the CPU 3 determines whether or not a page writing request flag is on (step S51). If the page writing request flag is off, the ROM writing process is terminated immediately, and in step 33, a command is received from the rewriting unit 2 and the process is migrated to the transfer data receiving process corresponding to the command so received.

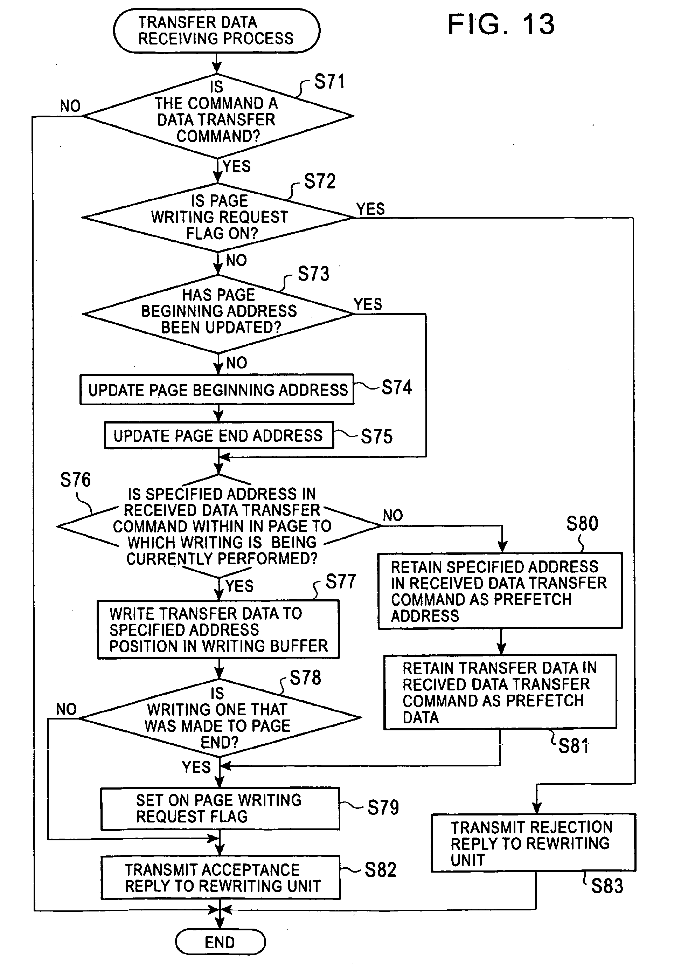

In the transfer data receiving process, as shown in Fig. 13, the CPU 3 determines whether or not a received command is a data transfer command (step S71). If the received command is the data transfer command, whether or not a page writing request flag is on is determined (step S72). If the page writing request flag is on, since data corresponding to one page formed in the writing buffer 15 has not yet been written to the ROM 10, a rejection response is transmitted to the rewriting unit 2 (step S83). When receiving the rejection response, the rewriting unit 2 is kept in a queued state until it receives an acceptance reply.

On the other hand, if the page writing request flag is off, whether or not a page beginning address has been updated is determined (step S73). If the page beginning address has not yet been updated, the page beginning address and page end address are updated, respectively (steps S74, S75). The page beginning address and page end address are calculated and updated according to the specified address in the data transfer command. On the other hand, if the page beginning address has already been update, jump to step S76 by bypassing steps S74 and S75.

In step S76, whether or not the specified address in the received data transfer command is in the page to which writing is being currently performed. If the specified address is an address within the page to which writing is being currently performed, the transfer data is written to a position of the writing buffer 15 specified by the specified address (step S77). Then, whether or not the writing was writing to the page end is determined (step S78). If the writing was writing to the page end, a page writing request flag is set on (step S79). If the writing was not writing to the page end, jump to step S82 by bypassing step S79.

If the result of the determination in step S76 indicates that the specified address is not an address within the page to which writing is being currently performed, the specified address in the received data transfer command is retained as a prefetch address (step S80), and the transfer data in the received data transfer command is retained as prefetch data (step S81). The prefetch address and prefetch data can be retained in the receiving buffer 13. Thereafter, the flow proceeds to step S79 to set on the page writing request flag.

After the step S79 has been executed, an acceptance reply is transmitted to the rewriting unit 2 (step S82).

An address portion that has not been written to the writing buffer 15 in this transfer data receiving process is a portion for which no data is transmitted to the ECU 1 from the rewriting unit 2, and the data in that portion remains at its initial value. Since data that is not transferred remains at the initial value, the data that is written to the writing buffer 15 as a result of step S77 is equal to the rewriting data stored in the memory 21.

In addition, if the step S79 is executed, in step S51 where a next ROM writing process is performed, the CPU 3 determines that the page writing request flag is on. Consequently, in that case, whether or not the writing of data to the specified page of the ROM 10 has been executed is determined (step S52). If the writing of data to the specified page of the ROM 10 has not yet been executed, the transfer data in the writing buffer 15 is written to the specified page of the ROM 10 (step S53). When the transfer data is written in step S53, the ROM writing process is completed.

If the writing of data to the specified page of the ROM 10 has been performed, the specified page of the ROM 10 is confirmed (step S54), and whether or not the writing of data to the specified pate has been completed is determined (step S55). If the writing of data has not yet been completed due to a writing error or the like, move to step S53 to write the transfer data in the writing buffer 15 to the specified page of the ROM 10. On the other hand, if the data writing has been completed, the writing buffer 15 is initialized (step S56). In step S56, as in step S25, the setting of the whole of the storage area of the writing buffer 15 to the initial value is performed.

Whether or not prefetch data is retained or not is determined (step S57) after the step S56 has been performed. If the prefetch data has not yet been retained, the page writing request flag is reset off (step S58). If the prefetch data is retained, the page beginning address and the page end address are updated, respectively, (steps S59, S60), the prefetch data is written to the specified address position in the writing buffer 15 (step S61). Then, whether or not the writing was writing to the page end is determined (step S62). If the writing is not writing to the page end, step S58 is executed to reset the page writing request flag off.

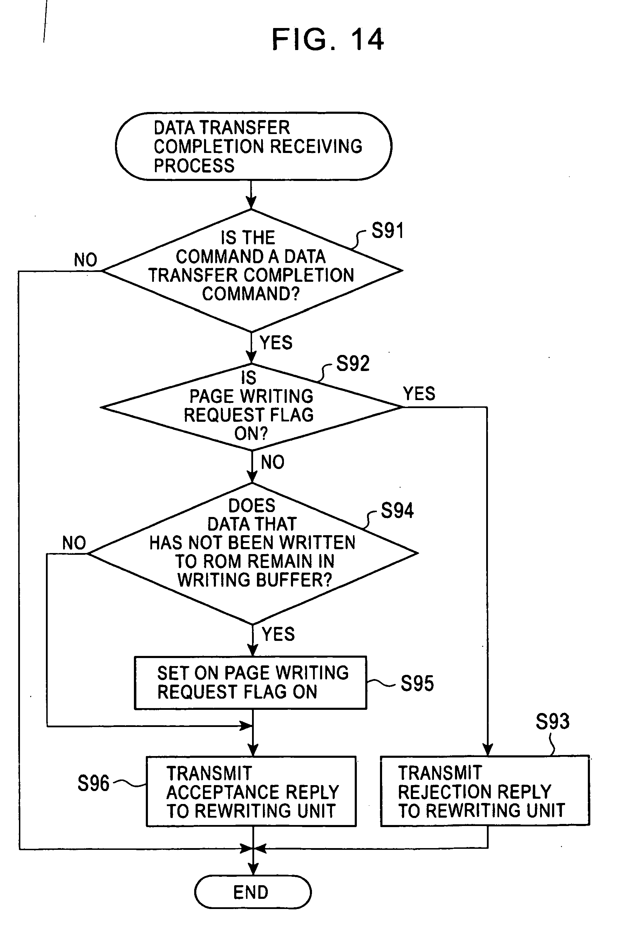

In the data transfer completion process, as shown in Fig. 14, the CPU 3 determines whether or not the received command is a data transfer completion command (step S91). If the received command is the data transfer completion command, whether or not the page writing request flag is on is determined (step S92). If the page writing request flag is on, since the writing of data formed in writing buffer 15 which corresponds to a page to the ROM 10 has not yet been completed, a rejection replay is transmitted to the rewriting unit (step S93).

If the page writing request flag is determined to be off in step S92, whether or not data that has not yet been written to the ROM 10 still remains in writing buffer 15 is determined (step S94). If data that has not yet been so written remains in the writing buffer 15, the page writing request flag is set on (step S95), and an acceptance replay is transmitted to the rewriting unit 2 (step S96). If data that has not yet been so written does not remain in the writing buffer 15, jump to step S96 by bypassing step S95, and an acceptance reply is transmitted to the rewriting unit 2.

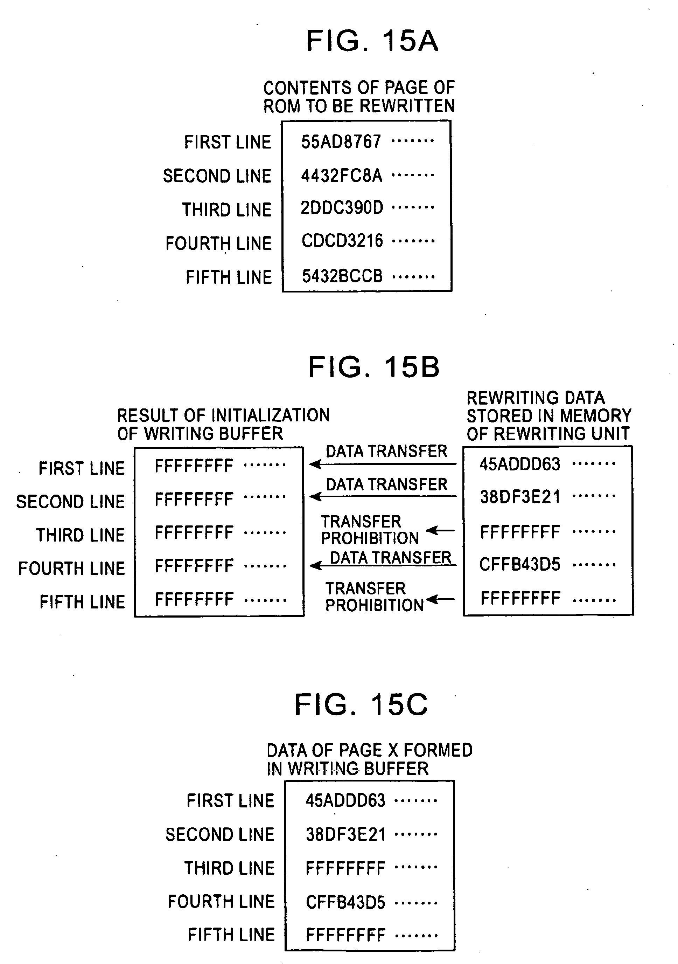

Assume that the contents of a page X of the ROM 10 that is to be rewritten by the operations of the ECU 1 that have been described heretofore or the contents of data before rewriting is as shown in Fig. 15A. The data contents are indicated by hexadecimal numbers. In addition, one line constitutes A bytes which is a data transfer unit. The contents of the page X all become trains of the initial value FF shown on a left-hand side of Fig. 15B by the initialization of the writing buffer 15. Assuming that data stored in the memory 21 of the rewriting unit 2 in such a manner as to correspond to the page X is such as shown on a right-hand side of Fig. 15B, data of A bytes on a first line is transmitted, and following that, data of A bytes on a second line is also transmitted. The contents of the first and second lines on the page X of writing buffer 15 are, as shown in Fig. 15C, rewritten by the transfer data. Since data of A bytes on a third line is all FF and is equal to the initial value, it is not transmitted. Consequently, the contents of the third line on the page X of the writing buffer 15 are not rewritten and remain as a train of the initial value FF. In addition, similarly, data of A bytes on a fourth line is transmitted and the contents of a fourth line on the page X of the writing buffer 15 are rewritten by them. Since data of A bytes on a fifth line of the memory 21 is all FF and is equal to the initial value, not being transferred, the contents of a fifth line on the page X of the writing buffer 15 are not rewritten and remain as a train of the initial value FF. As a result, the data on the page X of the writing buffer 15 becomes equivalent to the data stored in the memory 21, and the data is then written to the ROM 10.

Note that while in the embodiment, all the portions of the ROM 10 which are to be rewritten are initialized, only portions to which no data is transferred from the rewriting unit may be substituted by the initial value.

In addition, while in the embodiment, the ROM is used as the nonvolatile memory where the rewriting of the stored data is performed, a nonvolatile RAM or a hard disc device may be used.

Thus, as has been described heretofore, according to the invention, the rewriting unit transmits the rewriting data by the predetermined transfer unit as the data transfer command together with the specified position data representing the portion to be rewritten of the nonvolatile memory which corresponds to the rewriting data that are transmitted by the predetermined transfer unit and prohibits the transmission of the data transfer command including the rewriting data when the whole of the rewriting data that is transmitted by the predetermined transfer unit represents the initial value, and the on-board control unit receives the data transfer command transmitted from the rewriting unit, writes the rewriting data in each data transfer command so received to the portion to be rewritten of the nonvolatile memory that is represented by the specified position data in the data transfer command and writes the initial value to all the portions to be rewritten of the nonvolatile memory to which no rewriting data are obtained from the received data transfer command. Consequently, since the amount of data transferred from the rewriting unit to the on-board control unit can be reduced, as a result, the shortening of the rewriting time can be realized.

## Claims

1. A rewriting system in which rewriting data is transmitted from a rewriting unit (2) to an on-board control unit (1) having a nonvolatile memory (10) which stores data for executing at least control of an engine of a vehicle so as to rewrite the stored data in said nonvolatile memory (10), wherein
said rewriting unit (2) comprises transmission control means for transmitting the rewriting data for each predetermined data transfer unit as a data transfer command together with specified position data which represents a portion to be rewritten of said nonvolatile memory which corresponds to the rewriting data that is transmitted by the predetermined data transfer unit and prohibiting the transmission of the data transfer command which contains the rewriting data when the whole of the rewriting data that is transmitted by the predetermined data transfer unit represents a predetermined value, and wherein
said on-board control unit (1) comprises receiving means (12) for receiving the data transfer command transmitted from said rewriting unit, and
writing control means (3, 11) for writing the rewriting data contained in the data transfer command received by said receiving means (12) to the rewriting portion of said nonvolatile memory (11) represented by the specified position data in the data transfer command and writing data representing the predetermined value in all portions to be rewritten of said nonvolatile memory (10) where the rewriting data cannot be obtained from the data transfer command received by said receiving means (12).

2. A rewriting system according to claim 1, wherein
said writing control means (3, 11) includes :
a writing buffer (15) having a data storage area corresponding to a data rewriting unit of said nonvolatile memory (10);
initializing means for writing the data representing the predetermined value to the whole of the storage area of said writing buffer to initialize the writing buffer (15) ;
buffer writing means (14) for writing the rewriting data in the data transfer command received by the receiving means to a storage portion of the writing buffer (15) which is represented by the specified position data in the received data transfer command after the initialization of the writing buffer (15) by the initialization means; and
memory writing means (16) for writing the data stored in the writing buffer (15) to an area of the nonvolatile memory (10) which corresponds to the data rewriting unit when the writing of the rewriting data corresponding to the data rewriting unit of said nonvolatile memory (10) to said writing buffer (15) by said buffer writing means is completed.

3. A rewriting system according to claim 2, wherein said memory writing means (16) is adapted to determine that the writing of the rewriting data to said writing buffer (15) is completed when the writing of data to an end of the writing buffer (15) by said buffer writing means (16) is performed or when the specified position data in the data transfer command received by said receiving means (12) do not correspond to a current data storage area of said writing buffer (15).

4. A rewriting system according to claim 1, wherein the predetermined value is FF in hexadecimal representation.

5. An on-board control unit (1) having a nonvolatile memory (10) which stores data for executing at least control of an engine of a vehicle, the on-board control unit (1) comprising:
receiving means (12) for receiving a data transfer command transmitted from an external rewriting unit (2); and
writing control means (3,11) for writing rewriting data contained in the data transfer command received by the receiving means (12) to a portion to be rewritten of the nonvolatile memory (10) represented by specified position data in the data transfer command received and writing data representing a predetermined value in all portions to be rewritten of the nonvolatile memory (10) where the rewriting data cannot be obtained from the data transfer command received by the receiving means.

6. A rewriting unit (2) for transmitting to an on-board control unit (1) having a nonvolatile memory (10) which stores data for executing at least control of an engine of a vehicle rewriting data for rewriting the stored data in the nonvolatile memory (10), the rewriting unit (2) comprising:
transmission control means for transmitting the rewriting data for each predetermined data transfer unit as a data transfer command together with specified position data which represents a rewriting portion of the nonvolatile memory (10) which corresponds to the rewriting data that is transmitted by the predetermined data transfer unit and prohibiting the transmission of the data transfer command which contains the rewriting data when the whole of the rewriting data that is transmitted by the predetermined data transfer unit represents a predetermined value.

## Patentansprüche

1. System zum Wiedereinschreiben, bei dem Daten zum Wiedereinschreiben übertragen werden von einer Einheit zum Wiedereinschreiben (2) zu einer bordgestützten Steuereinheit (1) mit einem nichtflüchtigen Speicher (10), welcher Daten zum Ausführen zumindest der Steuerung eines Motors eines Fahrzeugs speichert, um die gespeicherten Daten in den nichtflüchtigen Speicher (10) wieder einzuschreiben, wobei
die Einheit zum Wiedereinschreiben (2) Übertragungssteuermittel zum Übertragen der Daten zum Wiedereinschreiben für jede vorbestimmte Datentransfereinheit als einen Datentransferbefehl zusammen mit spezifizierten Positionsdaten, die einen wieder einzuschreibenden Abschnitt des nichtflüchtigen Speichers darstellen, aufweist, wobei der Abschnitt den Daten zum Wiedereinschreiben entspricht, die von der vorbestimmten Datentransfereinheit übertragen werden, und zum Vermeiden der Übertragung des Datentransferbefehls, der die Daten zum Wiedereinschreiben enthält, wenn die gesamten Daten zum Wiedereinschreiben, die von der vorbestimmten Datentransfereinheit übertragen werden, einen vorbestimmten Wert darstellen, und wobei
die bordgestützte Steuereinheit (1) Empfangsmittel (12) zum Empfangen des Datentransferbefehls, der von der Einheit zum Wiedereinschreiben übertragen wird, und
Schreibsteuerungsmittel (3, 11) aufweist zum Schreiben der Daten zum Wiedereinschreiben, die in dem von den Empfangsmitteln (12) empfangenen Datentransferbefehl enthalten sind, in den Abschnitt zum Wiedereinschreiben des nichtflüchtigen Speichers (11), dargestellt durch die spezifizierten Positionsdaten in dem Datentransferbefehl und Schreibdaten, die den vorbestimmten Wert in allen Abschnitten zum Wiedereinschreiben des nichtflüchtigen Speichers (10) darstellen, wobei die Daten zum Wiedereinschreiben nicht aus dem Datentransferbefehl erhalten werden können, der von den Empfangsmitteln (12) empfangen wird.

2. System zum Wiedereinschreiben nach Anspruch 1, wobei die Schreibsteuerungsmittel (3, 11) aufweisen:
einen Schreibpuffer (15) mit einem Datenspeicherbereich, der einer Einheit zum Wiedereinschreiben von Daten des nichtflüchtigen Speichers (10) entspricht;
Initialisierungsmittel zum Schreiben der Daten, die den vorbestimmten Wert darstellen, in den gesamten Speicherbereich des Schreibpuffers, um den Schreibpuffer (15) zu initialisieren;
Pufferschreibmittel (14) zum Schreiben der Daten zum Wiedereinschreiben in den Datentransferbefehl, der von den Empfangsmitteln erhalten wird, in einen Speicherabschnitt des Schreibpuffers (15), der durch die spezifizierten Positionsdaten in dem empfangenen Datentransferbefehl nach der Initialisierung des Schreibpuffers (15) durch die Initialisierungsmittel dargestellt ist; und
Speicherschreibmittel (16) zum Schreiben der Daten, die in dem Schreibpuffer (15) gespeichert sind, in einen Bereich des nichtflüchtigen Speichers (10), der der Einheit zum Wiedereinschreiben von Daten entspricht, wenn das Schreiben der Daten zum Wiedereinschreiben der Einheit zum Wiedereinschreiben von Daten des nichtflüchtigen Speichers (10) entspricht, in den Schreibpuffer (15) durch die Pufferschreibmittel abgeschlossen ist.

3. System zum Wiedereinschreiben nach Anspruch 2, wobei die Speicherschreibmittel (16) dafür geeignet sind, zu bestimmen, dass das Schreiben der Daten zum Wiedereinschreiben in den Schreibpuffer (15) abgeschlossen ist, wenn das Schreiben von Daten in ein Ende des Schreibpuffers (15) durch die Pufferschreibmittel (16) durchgeführt wurde oder wenn die spezifizierten Positionsdaten in dem Datentransferbefehl, der von den Empfangsmitteln (12) empfangen wird, keinem aktuellen Datenspeicherbereich des Schreibpuffers (15) entsprechen.

4. System zum Wiedereinschreiben nach Anspruch 1, wobei der vorbestimmte Wert FF in Hexadezimaldarstellung ist.

5. Bordgestützte Steuereinheit (1) mit einem nichtflüchtigen Speicher (10), der Daten zum Ausführen zumindest der Steuerung eines Motors eines Fahrzeugs speichert, wobei die bordgestützte Steuereinheit (1) aufweist:
Empfangsmittel (12) zum Empfangen eines Datentransferbefehls, der von einer externen Einheit zum Wiedereinschreiben (2) übertragen wird; und
Schreibsteuerungsmittel (3, 11) zum Schreiben von Daten zum Wiedereinschreiben, die in dem Datentransferbefehl enthalten sind, der von den Empfangsmitteln (12) empfangen wird, in einen wieder einzuschreibenden Abschnitt des nichtflüchtigen Speichers (10), dargestellt durch spezifizierte Positionsdaten in dem empfangenen Datentransferbefehl und Schreibdaten, die einen vorbestimmten Wert in allen wieder einzuschreibenden Abschnitten des nichtflüchtigen Speichers (10) darstellen, wo die Daten zum Wiedereinschreiben nicht von dem Datentransferbefehl erhalten werden können, der von den Empfangsmitteln empfangen wird.

6. Einheit zum Wiedereinschreiben (2) zur Übertragung an eine bordgestützte Steuereinheit (1) mit einem nichtflüchtigen Speicher (10), der Daten zum Ausführen zumindest der Steuerung eines Motors eines Fahrzeugs speichert, von Daten zum Wiedereinschreiben zum Wiedereinschreiben der gespeicherten Daten in den nichtflüchtigen Speicher (10), wobei die Einheit zum Wiedereinschreiben (2) aufweist:
Übertragungssteuermittel zum Übertragen der Daten zum Wiedereinschreiben für jede vorbestimmte Datentransfereinheit als einen Datentransferbefehl zusammen mit spezifizierten Positionsdaten, die einen Abschnitt zum Wiedereinschreiben des nichtflüchtigen Speichers (10) darstellen, der den Daten zum Wiedereinschreiben entspricht, die von der vorbestimmten Datentransfereinheit übertragen werden, und zum Vermeiden der Übertragung des Datentransferbefehls, der die Daten zum Wiedereinschreiben enthält, wenn die gesamten Daten zum Wiedereinschreiben, die von der vorbestimmten Datentransfereinheit übertragen werden, einen vorbestimmten Wert darstellen.

## Revendications

1. Système de réécriture dans lequel des données de réécriture sont transmises d'une unité de réécriture (2) à un système de contrôle embarqué (1) ayant une mémoire non volatile (10) qui stocke des données pour exécuter au moins le contrôle d'un moteur d'un véhicule, de manière à réécrire les données stockées dans ladite mémoire non volatile (10),
dans lequel ladite unité de réécriture (2) comporte un dispositif de contrôle de la transmission destiné à transmettre les données de réécriture pour chaque unité de transfert de données prédéterminée sous forme d'une commande de transfert de données conjointement avec des données de position spécifiée qui représente une partie de ladite mémoire non volatile devant être réécrite qui correspond aux données de réécriture transmises par l'unité de transfert de données prédéterminée et destiné à empêcher la transmission de la commande de transfert de données qui contient les données de réécriture quand l'ensemble des données de réécriture transmises par l'unité de transfert de données prédéterminée représente une valeur prédéterminée,
et dans lequel ledit système de contrôle embarqué (1) comporte un dispositif de réception (12) destiné à recevoir la commande de transfert de données transmise de ladite unité de réécriture,
et un dispositif de contrôle d'écriture (3, 11) destiné à écrire les données de réécriture contenues dans la commande de transfert de données reçue par ledit dispositif de réception (12) dans la zone de réécriture de ladite mémoire non volatile (11) représentée par les données de position spécifiée dans la commande de transfert de données et par les données d'écriture représentant la valeur prédéterminée dans toutes les zones de ladite mémoire non volatile (10) devant être réécrites, où les données de réécriture ne peuvent pas être obtenues à partir de la commande de transfert de données reçue par ledit dispositif de réception (12).

2. Système de réécriture selon la revendication 1, dans lequel ledit dispositif de contrôle d'écriture (3, 11) comprend:
un tampon d'écriture (15) ayant une zone de stockage de données correspondant à une unité de réécriture de données de ladite mémoire non volatile (10);
un dispositif d'initialisation destiné à écrire les données représentant la valeur prédéterminée dans l'ensemble de la zone de stockage dudit tampon d'écriture pour initialiser le tampon d'écriture (15) ;
un dispositif d'écriture tampon (14) destiné à écrire les données de réécriture contenues dans la commande de transfert de données reçue par le dispositif de réception dans une zone de stockage du tampon d'écriture (15) qui est représenté par les données de position spécifiée dans la commande de transfert de données reçue après l'initialisation du tampon d'écriture (15) par le dispositif d'initialisation ; et
un dispositif d'écriture mémoire (16) destiné à écrire les données stockées dans le tampon d'écriture (15) dans une zone de la mémoire non volatile (10) qui correspond à l'unité de réécriture de données quand l'écriture des données de réécriture correspondant à l'unité de réécriture de données de ladite mémoire non volatile (10) dans ledit tampon d'écriture (15) par ledit dispositif d'écriture tampon est achevée.

3. Système de réécriture selon la revendication 2, dans lequel le dispositif d'écriture mémoire (16) est adapté pour déterminer que l'écriture des données de réécriture dans ledit tampon d'écriture (15) est achevée quand l'écriture de données à la fin du tampon d'écriture (15) par ledit dispositif d'écriture tampon (16) est exécuté ou quand les données de position spécifiée dans la commande de transfert de données reçue par ledit dispositif de réception (12) ne correspond pas à une zone de stockage de données actuelle dudit tampon d'écriture (15).

4. Système de réécriture selon la revendication 1, dans lequel la valeur prédéterminée est FF en représentation hexadécimale.

5. Système de contrôle embarqué (1) ayant une mémoire non volatile (10) qui stocke des données pour exécuter au moins le contrôle d'un moteur d'un véhicule, le système de contrôle embarqué (1) comportant:
un dispositif de réception (12) destiné à recevoir une commande de transfert de données transmise à partir d'une unité de réécriture externe (2) ; et
un dispositif de contrôle d'écriture (3, 11) destiné à écrire des données de réécriture contenues dans la commande de transfert de données reçue par le dispositif de réception (12) dans une zone de réécriture de la mémoire non volatile (10) représentée par des données de position spécifiée dans la commande de transfert de données et par des données d'écriture représentant une valeur prédéterminée dans toutes les zones de la mémoire non volatile (10) devant être réécrites, où les données de réécriture ne peuvent pas être obtenues à partir de la commande de transfert de données reçue par le dispositif de réception.

6. Unité de réécriture (2) destinée à transmettre à un système de contrôle embarqué (1) ayant une mémoire non volatile (10) qui stocke des données pour exécuter au moins le contrôle d'un moteur d'un véhicule des données de réécriture pour réécrire les données stockées dans la mémoire non volatile (10), l'unité de réécriture (2) comportant:
un dispositif de contrôle de la transmission destiné à transmettre les données de réécriture pour chaque unité de transfert de données prédéterminée sous forme d'une commande de transfert de données conjointement avec des données de position spécifiée qui représente une partie de la mémoire non volatile (10) devant être réécrite qui correspond aux données de réécriture transmises par l'unité de transfert de données prédéterminée et destiné à empêcher la transmission de la commande de transfert de données qui contient les données de réécriture quand l'ensemble des données de réécriture transmises par l'unité de transfert de données prédéterminée représente une valeur prédéterminée.
